# EUROPEAN PATENT APPLICATION

(11) **EP 4 447 641 A1**
(43) Date of publication of application: **16.10.2024**
(21) Application number: 24165886.3
(22) Date of filing: 25.03.2024
(51) Int. Cl.: H10K 59/131, H10K 59/124, H10K 59/80, H10K 50/844

(54) **DISPLAY DEVICE AND MANUFACTURING METHOD THEREOF**

(30) Priority: 06.04.2023 US 202363494528 P; 12.10.2023 CN 202311322936
(71) Applicant: Taizhou Guanyu Technology Co., Ltd., Taizhou City, Zhejiang Province (CN)
(72) Inventor: HSU, KUO-CHENG, 406 TAICHUNG CITY (TW); CHU, KER TAI, 11494 TAIPEI CITY (TW); CHEN, HUEI-SIOU, 103 TAIPEI CITY (TW)
(74) Representative: Michalski Hüttermann & Partner Patentanwälte mbB

(57) **Abstract**

The disclosure provides a display device including a substrate, a first interconnection metal layer, a second interconnection metal layer, a passivation layer, a first through via, a second through via, a first electrode and a bonding pad. The substrate includes active and border regions. The first interconnection metal layer is disposed on the substrate and located in the active region. The second interconnection metal layer is disposed on the substrate and located in the border region. The passivation layer is disposed on the first and second interconnection metal layers. The first through via passes through the passivation layer and is electrically connected to the first interconnection metal layer. The second through via passes through the passivation layer and is electrically connected to the second interconnection metal layer. The first electrode is disposed on the first through via. The bonding pad is disposed on the second through via.

## Description

### CROSS-REFERENCE TO RELATED APPLICATIONS

This application claims priority of Chinese patent applications entitled "DISPLAY DEVICE AND MANUFACTURING METHOD THEREOF" filed on October 12, 2023 (Application No. 202311322936.1), and claims priority of U.S. Provisional Application No. 63/494,528, filed on April 6, 2023; the entire contents of which are incorporated by reference in this application.

### BACKGROUND OF THE PRESENT DISCLOSURE

### FIELD OF THE PRESENT DISCLOSURE

The present disclosure relates to a display device, and more particularly to a display device having a through via.

### DESCRIPTION OF THE PRIOR ART

Display devices including an optical component layer are extensively applied in most electronic apparatuses, and there has been an increasing demand for large-scale display devices in the recent years. However, a method for manufacturing a display device contains steps with poor light extraction rates. In fact, one commonly known challenge is how to improve the light extraction rate of a display device. Thus, the industry of display devices seeks a method for solving the issues above.

### SUMMARY OF THE PRESENT DISCLOSURE

A display device includes a substrate, a first interconnection metal layer, a second interconnection metal layer, a passivation layer, a first through via, a second through via, a first electrode and a bonding pad. The substrate includes an active region and a border region. The first interconnection metal layer is disposed on the substrate and located in the active region. The second interconnection metal layer is disposed on the substrate and located in the border region. The passivation layer is disposed on the first interconnection metal layer and the second interconnection metal layer. The first through via passes through the passivation layer and is electrically connected to the first interconnection metal layer. The second through via passes through the passivation layer and is electrically connected to the second interconnection metal layer. The first electrode is disposed on the first through via. The bonding pad is disposed on the second through via.

A method for manufacturing a display device includes: providing a substrate including an active region and a border region; forming a first interconnection metal layer on the substrate and in the active region; forming a second interconnection metal layer on the substrate and in the border region; forming a passivation layer on the first interconnection metal layer and the second interconnection metal layer; forming a first through via passing through the passivation layer and electrically connected to the first interconnection metal layer; forming a second through via passing through the passivation layer and electrically connected to the second interconnection metal layer; forming a first electrode on the first through via; and forming a bonding pad on the second though via.

### BRIEF DESCRIPTION OF THE DRAWINGS

FIG. 1A is a plan view of a display device according to some embodiments;
FIG. 1B is a section diagram of the display device in FIG. 1A according to some embodiments;
FIG. 2 is a section diagram of a display device according to some embodiments; and
FIGS. 3A, 3B, 3C, 3D, 3E, 3F, 3G and 3H are diagrams of a display device in different manufacturing stages of a method according to some embodiments of the present disclosure.

### DETAILED DESCRIPTION OF THE EMBODIMENTS

Numerous different embodiments or examples are provided in the present disclosure below to implement different characteristics of the present application. Specific examples of components and configurations are as described below in the aim of simplifying the disclosure of the present application. However, these examples are merely examples and are not to be construed as limitations to the present application. For example, a first feature formed on, over or above a second feature can include an embodiment in which the first and second features are in direct contact, and can also include an embodiment in which another feature is formed between the first and second features and the first and second features are thus not in direct contact. Moreover, numerals, symbols and/or letters may be repeated in different components. Such repetition is for the purpose of simplicity and clarity, and does not dictate relations between the various embodiments and/or structures discussed.

In addition, spatial correspondence terms used in the present application such as "under", "lower than", "below", "more that", "higher than" and the like can be used for simple description so as to explain a relation of one component or feature in a drawing with respect to another component or feature.

In addition to orientations illustrated in the drawings, these spatial correspondence terms further include different orientations of an apparatus in use or in operation. An apparatus can be oriented (rotated by 90 degrees or other orientations), and the spatial correspondence description used in the present application can be interpreted accordingly.

Despite that numeric ranges and parameters disclosed in the broadest range of the present disclosure are approximate values, the values stated in specific embodiments are to be as accurate as possible. However, any numeral intrinsically includes a certain error caused by a standard deviation obtained from individual testing and measurement. Moreover, in the literature below, the term "about/approximately" usually refers to less than 5%, 1% or 0.5% of a predetermined value or range. Alternatively, the term "about/approximate" refers to within an acceptable standard error of a mean value considered by a person of ordinary skill in the art. Apart from operation /working examples, unless otherwise specified, it is to be understood that the amount, period of time, temperature, operating conditions, ratio of quantity of materials, as well as all numerical ranges, quantities, values and ratios of the like, are to be modified by the term "about/approximate" in all circumstances. Thus, unless described otherwise, the numerical values and parameters of the claims set forth in the present disclosure can be regarded as approximate value that are variable according to requirements. Each numerical value or parameter is to be interpreted at least in light of a quantity of effective numbers reported and by applying common rounding techniques. In the present disclosure, a range can represent from one endpoint to the other endpoint, or between these two endpoints. Unless otherwise specified, all ranges disclosed in the present literature include endpoints.

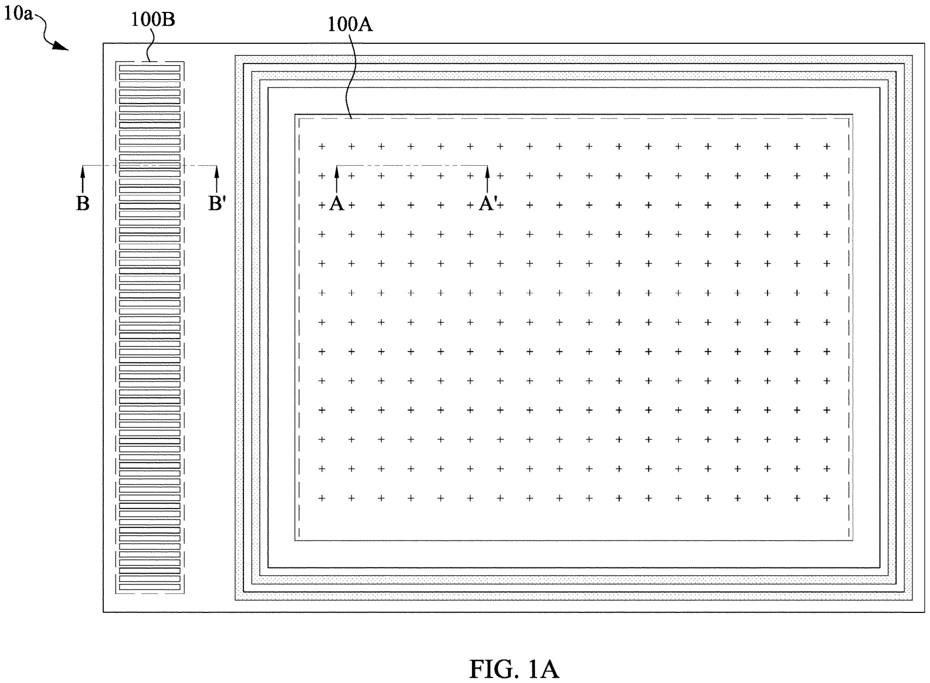

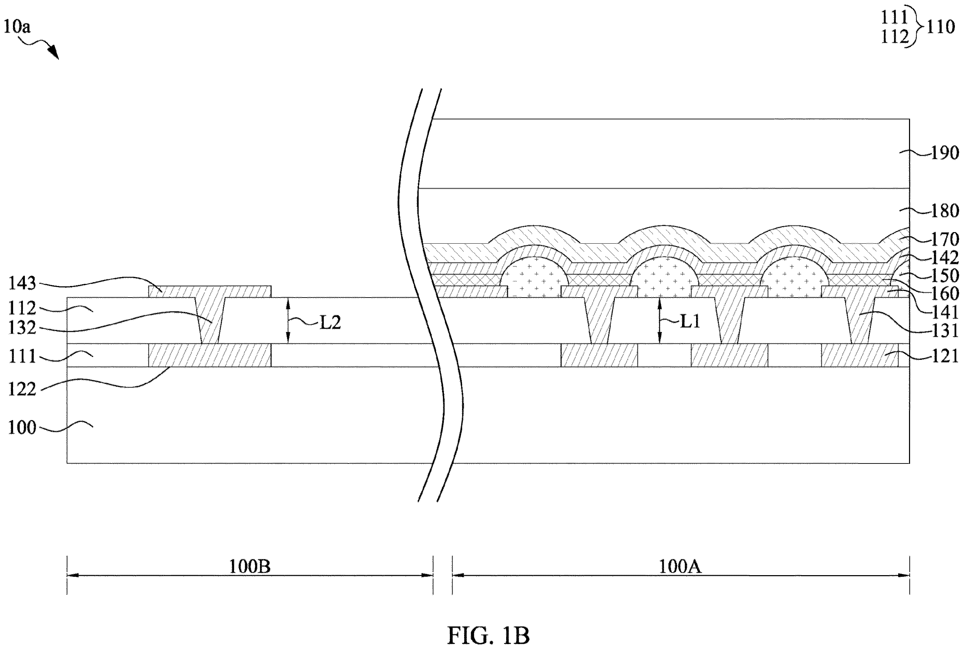

FIG. 1A and FIG. 1B illustrate a display device 10a according to some embodiments. The display device 10a can include a substrate 100. The substrate 100 includes a base material (not shown), a dielectric layer (not shown), and one or more circuits (not shown) disposed on the base material or in the base material. In some embodiments, the base material is a transparent base material, or is at least partially transparent. In some embodiments, the base material is a non-flexible base material, and a material of such base material can include glass, quartz, low-temperature polysilicon (LTPS), or other appropriate materials. In some embodiments, the base material is a flexible substrate, and a material of such base material can include transparent epoxy resin, polyimide, polyvinyl chloride, methyl methacrylate or other appropriate materials. The dielectric layer is disposed on the base material as needed. In some embodiments, the dielectric layer can include silicon oxide, silicon nitride, silicon oxynitride, or other appropriate materials.

In some embodiments, the circuit can include a complementary metal oxide semiconductor (CMOS) circuit, or multiple transistors and multiple capacitors adjacent to the transistors, wherein the transistors and the capacitors are formed on the dielectric layer. In some embodiments, the transistors include thin-film transistors (TFT). Each of the transistors includes a source/drain region (including at least one source region and one drain region), a channel region located in the source-drain region, a gate electrode disposed above the channel region, and a gate insulator located between the channel region and the gate electrode. The channel region of the transistor can be formed of a semiconductor material, for example, silicon or other elements selected from group IV or group III and group V.

The substrate 100 can include an active region 100A and a border region 100B. The active region 100A can be configured to emit light. The active region 100A can include a plurality of pixels, each of which can be configured to emit light of a predetermined wavelength, for example, green light (for example, light of a wavelength between 500 nm and 580 nm), red light (for example, light of a wavelength between 620 nm and 780 nm), blue light (for example, light of a wavelength between 400 nm and 500 nm), infrared light, ultraviolet light and/or white light. In some embodiments, the active region 100A can include a light emitting diode (LED), an organic light emitting diode (OLED), a quantum dot light emitting diode (QLED) and/or other appropriate light emitting modules. The border region 100B can be configured to be electrically connected to an external circuit (not shown), which can be a driver chip, a circuit board and/or other appropriate circuits.

In some embodiments, the display device 10a includes an interlayer dielectric structure 110. The interlayer dielectric structure 110 can be disposed on the substrate 100. The interlayer dielectric structure 110 can include a plurality of passivation layers. For example, the interlayer dielectric structure 110 includes a passivation layer 111 and a passivation layer 112. The passivation layer 111 can be disposed on the substrate 100 and include a dielectric material, for example, silicon oxide, borophosphosilicate glass (BPSG) or other appropriate materials.

In some embodiments, the display device 10a includes an interconnection metal layer 121 and an interconnection metal layer 122. The interconnection metal layer 121 is disposed on the substrate 100 and located in the active region 100A. The interconnection metal layer 121 is embedded in the passivation layer 111. The interconnection metal layer 121 can be electrically connected to a TFT, an interconnection metal layer or other appropriate components in the substrate 100. In some embodiments, the interconnection metal layer 121 can be a fourth metal layer M4, a fifth metal layer M5, a sixth metal layer M6 or located on other appropriate horizontal layers. The interconnection metal layer 121 can include a conductive material, for example, a metal, a metal nitride, an alloy and/or other appropriate materials. It should be noted that, other interconnection metal layers, for example, a first metal layer M1 and a second metal layer M2 can be located in the substrate 100, and be electrically connected to the interconnection metal layer 121 and/or the interconnection metal layer 122.

The interconnection metal layer 122 is disposed on the substrate 100 and located in the border region 100B. The interconnection metal layer 122 is embedded in the passivation layer 111. A height of the interconnection metal layer 122 relative to the substrate 100 can be equal to a height of the interconnection metal layer 121 relative to the substrate 100. In some embodiments, a surface area (for example, a surface area of an upper surface) of the interconnection metal layer 122 can be greater than a surface area of the interconnection metal layer 121. In some embodiments, a width of the interconnection metal layer 122 can be greater than a width of the interconnection metal layer 121 in a cross-sectional view. In some embodiments, the interconnection metal layers 121 and 122 include a stacked structure including titanium nitride (TiN)/aluminum (Al)/ titanium nitride (TiN).

The passivation layer 112 is disposed on the passivation layer 111. The passivation layer 112 is disposed on the interconnection metal layer 121. The passivation layer 112 is disposed on the interconnection metal layer 122. A material forming the passivation layer 112 can be the same as a material forming the passivation layer 111.

In some embodiments, the display device 10a includes a through via 131 (or conductive via). The through via 131 is located in the active region 100A. The through via 131 can be disposed on the interconnection metal layer 121 and electrically connected to the interconnection metal layer 121. The through via 131 can pass through the passivation layer 112. The through via 131 has a length L1 (or depth).

In some embodiments, the display device 10a includes a through via 132. The through via 132 is located in the border region 100B. The through via 132 can be disposed on the interconnection metal layer 122 and electrically connected to the interconnection metal layer 122. The through via 132 can pass through the passivation layer 112. The through via 132 has a length L2 (or depth). In some embodiments, the length L1 is fundamentally equal to the length L2. In some embodiments, an aperture of the through via 132 is fundamentally equal to an aperture of the through via 131. In some embodiments, the through vias 131 and 132 include tungsten (W), titanium (TiN), and other suitable materials.

In some embodiments, the display device 10a includes an electrode 141. The electrode 141 is disposed on the through via 131 and electrically connected to the interconnection metal layer 121. The electrode 141 can define a plurality of openings, and a surface of the passivation layer 112 can be exposed from the openings of the electrode 141. The electrode 141 includes a metal material, for example, Ag and Mg. In some embodiments, the electrode 141 includes indium tin oxide (ITO), indium zinc oxide (IZO) or other appropriate materials. In some embodiments, the electrode 141 includes a stacked structure including titanium nitride (TiN)/aluminum (Al)/ titanium nitride (TiN).

In some embodiments, the display device 10a includes a pixel defining layer 150. The pixel defining layer 150 can be disposed on a surface of the interconnection metal layer 121. The pixel defining layer 150 can cover a part of the electrode 141. The pixel defining layer 150 can be used to define a position of a pixel. The pixel defining layer 150 can be used to define a light emitting area and/or profile of a pixel. In some embodiments, the pixel defining layer 150 includes a light absorbing material having an absorbance greater than 85%, for example, 85%, 88%, 90%, 93%, 95%, 97%, 98% or 99%. The pixel defining layer 150 can include an organic material, for example, a photoresist or other appropriate materials.

In some embodiments, the display device 10a includes a light emitting structure 160. The light emitting structure 160 can be disposed on the electrode 141. The light emitting structure 160 can be located in an opening defined by the pixel defining layer 150. In some embodiments, the light emitting structure 160 can include a multi-layer composite structure. For example, the light emitting structure 160 can include a carrier injection layer, a hole transport layer (HTL), an electron transport layer (ETL), an emissive layer (EML) and/or other appropriate materials. The carrier injection layer is for injecting holes and/or electrons. The hole transport layer and the electron transport layer having characteristics of uni-directionally transporting electrons or holes. The emissive layer can include different materials at different pixels so as to emit light of wavelengths within different wavebands, for example, red light, green light, blue light, white light, ultraviolet light, infrared light and/or light of other wavebands.

In some embodiments, the display device 10a includes an electrode 142. The electrode 142 is disposed on the light emitting structure 160. A material forming the electrode 142 can be the same as or similar to a material forming the electrode 141.

In some embodiments, the display device 10a includes a film layer 170 (or a film). The film layer 170 can serve as a buffer layer and/or protection layer, so as to prevent the components below from damage. The film layer 170 can be disposed in the active region 100A. In some embodiments, the through via 132 is not in contact with the film layer 170. In some embodiments, the through via 132 is free from being covered by the film layer 170. The film layer 170 can include a dielectric material. The film layer 170 can be conformally disposed on the electrode 142.

In some embodiments, the display device 10a includes a flat layer 180. The flat layer 180 is disposed on the film layer 170. The flat layer 180 includes a substantially transparent material, for example, resin or other appropriate materials, and can include any desired filler.

In some embodiments, the display device 10a includes a cover plate 190. The cover plate 190 can be disposed in the active region 100A. The border region 100B is not covered by the cover plate 190. The cover plate 190 is disposed on the flat layer 180. In some embodiments, the cover plate 190 includes a substantially transparent component, for example, glass or other appropriate components.

In some embodiments, the display device 10a includes a bonding pad 143. The bonding pad 143 is disposed on the through via 132 and electrically connected to the interconnection metal layer 122. The bonding pad 143 can be used to electrically connect to an external circuit, for example, a driver chip, a circuit board and/or other appropriate circuits. In some embodiments, a height of the bonding pad 143 relative to the substrate 100 can be substantially equal to a height of the electrode 141 relative to the substrate 100. In some embodiments, the height of the bonding pad 143 relative to the interconnection metal layer 122 may be substantially equal to the height of the electrode 141 relative to the interconnection metal layer 121. In some embodiments, the bonding pad 143 includes a stacked structure including titanium nitride (TiN)/aluminum (Al)/ titanium nitride (TiN).

A conventional display device is provided without the through via 132 and without the bonding pad 143. In subsequent processes, it is possible that the active region 100A and the border region 100B receive different stresses, leading to an occurrence of mura in light emitted from pixels. In this embodiment, the interconnection metal layer 122, the through via 132 and the bonding pad 143 can be used to balance the stresses of the active region 100A and the border region 100B, hence preventing the occurrence of mura. Further, in a conventional display device, the interconnection metal layer 122 is configured to be directly connected to an external device. In this condition, the passivation layer will be patterned by an additional mask, which increases a cost. Further, in a conventional display device, the upper titanium nitride layer, which is over the aluminum layer, is etched when patterning the passivation layer.

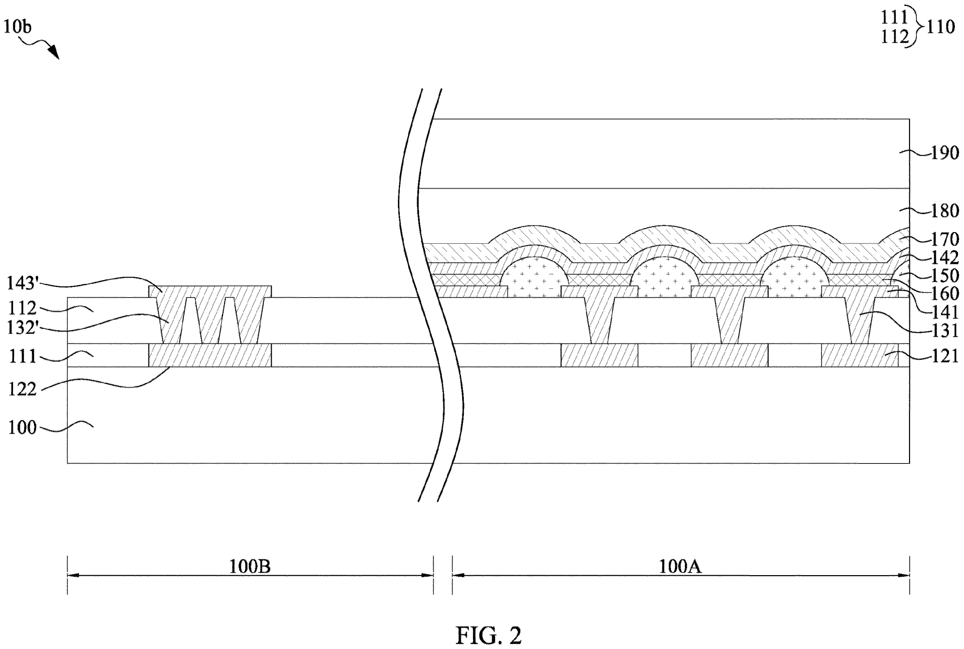

FIG. 2 shows a section diagram of a display device 10b according to some embodiments. The display device 10b can be similar to the display device 10a, and includes a through via 132' and a bonding pad 143'. In some embodiments, in a horizontal direction (a normal direction perpendicular to the surface of the substrate 100), the display device 10b includes a plurality of through vias 132' electrically connected to the bonding pad 143'. In this embodiment, by controlling the number and density of the through vias 132', impedance can be controlled so as to achieve better performance.

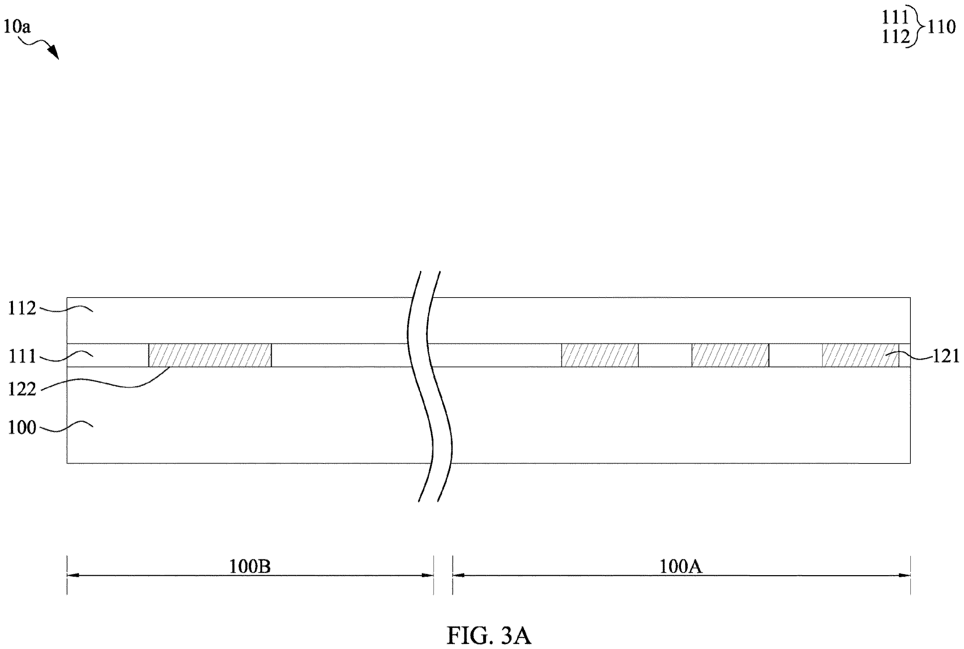

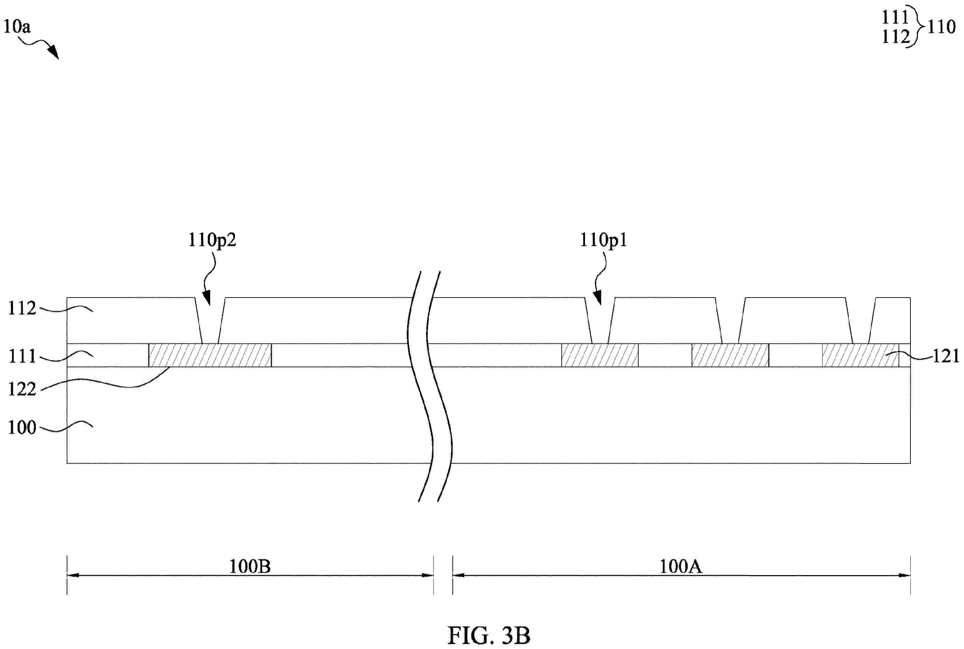

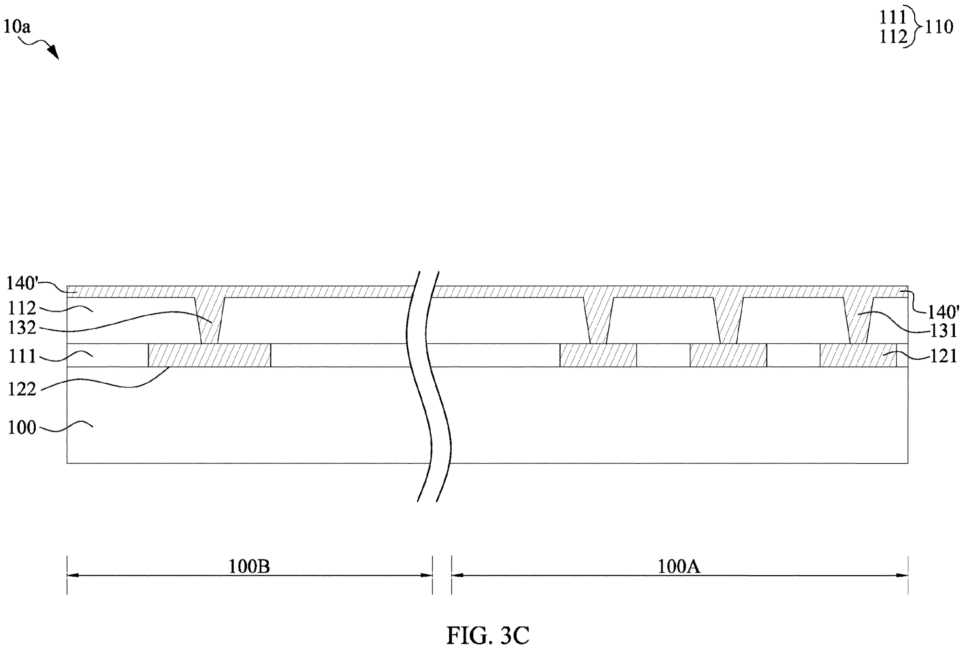

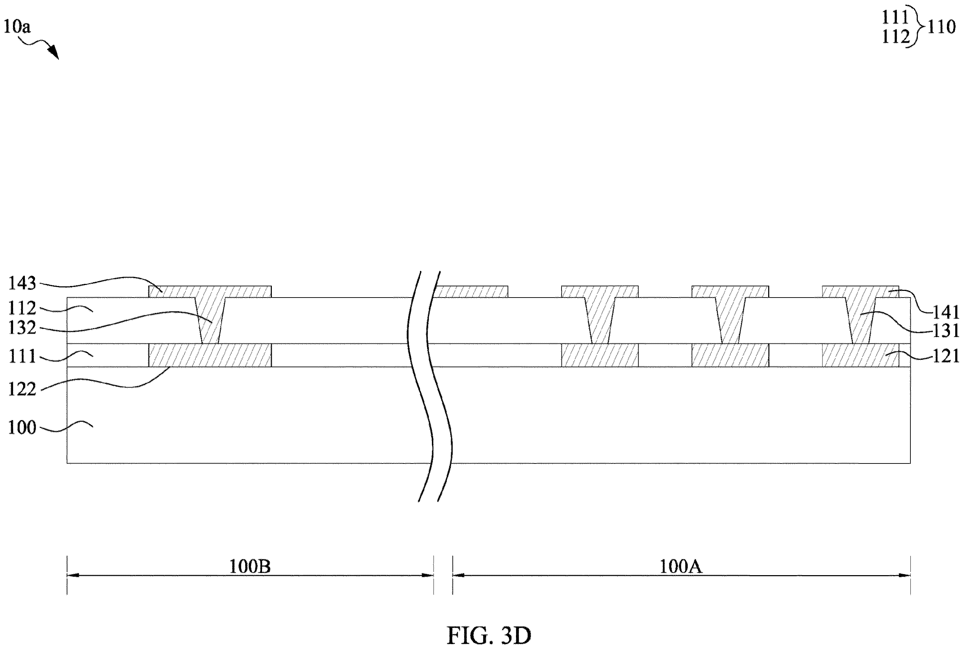

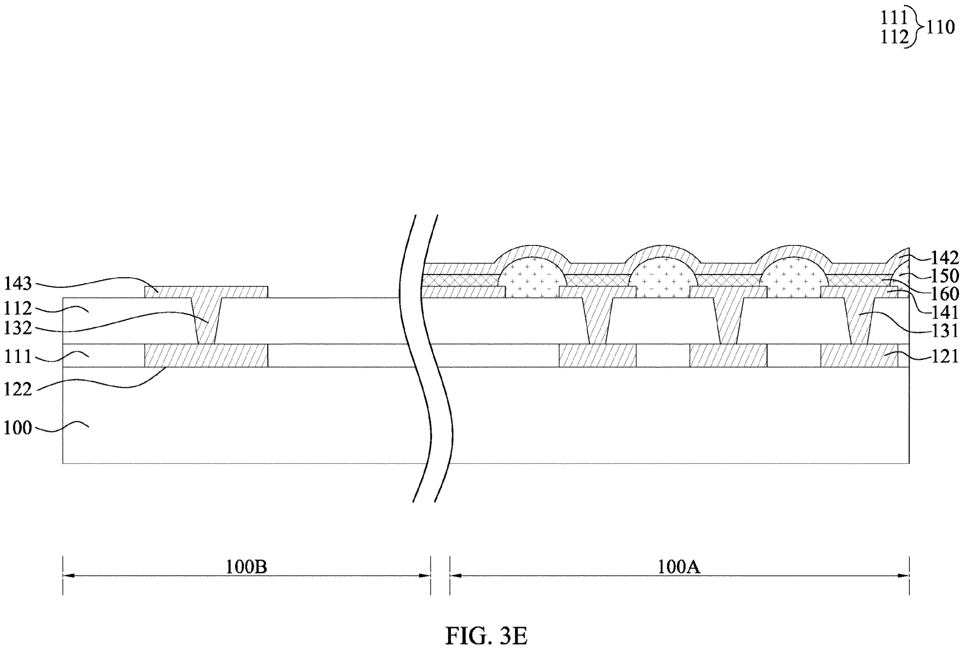

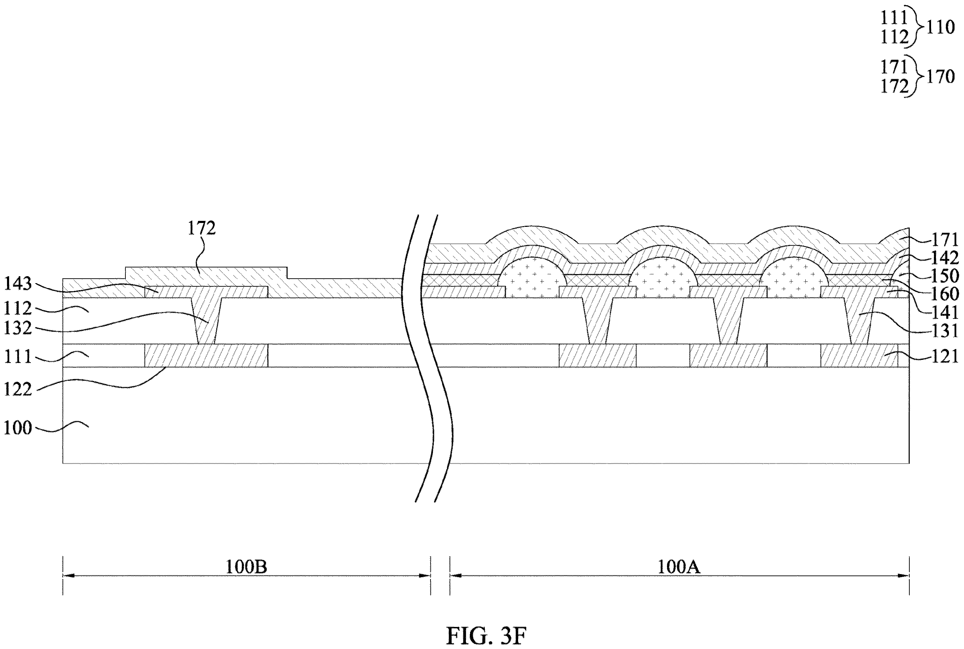

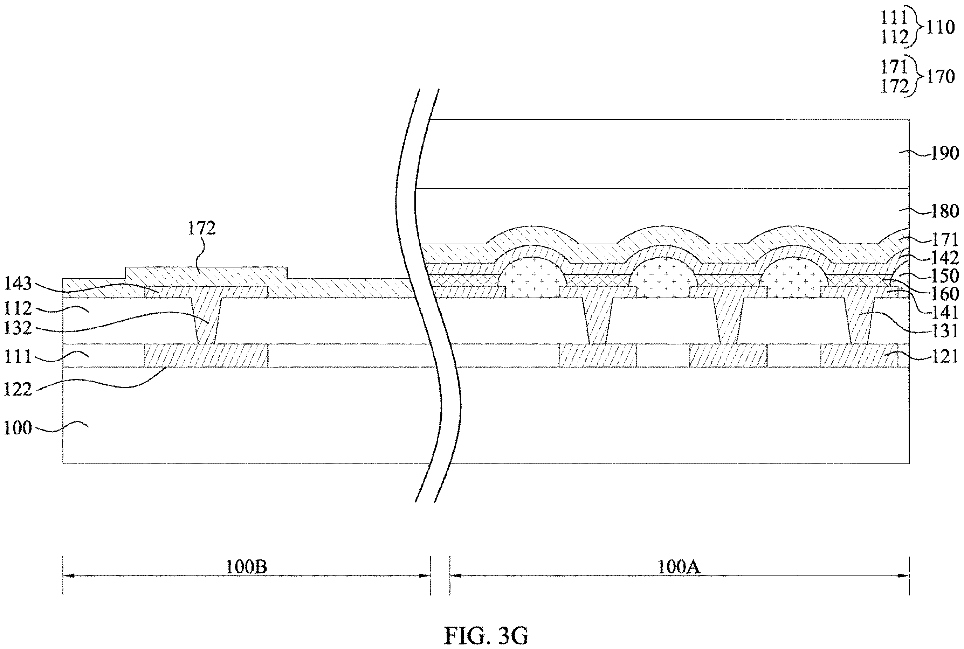

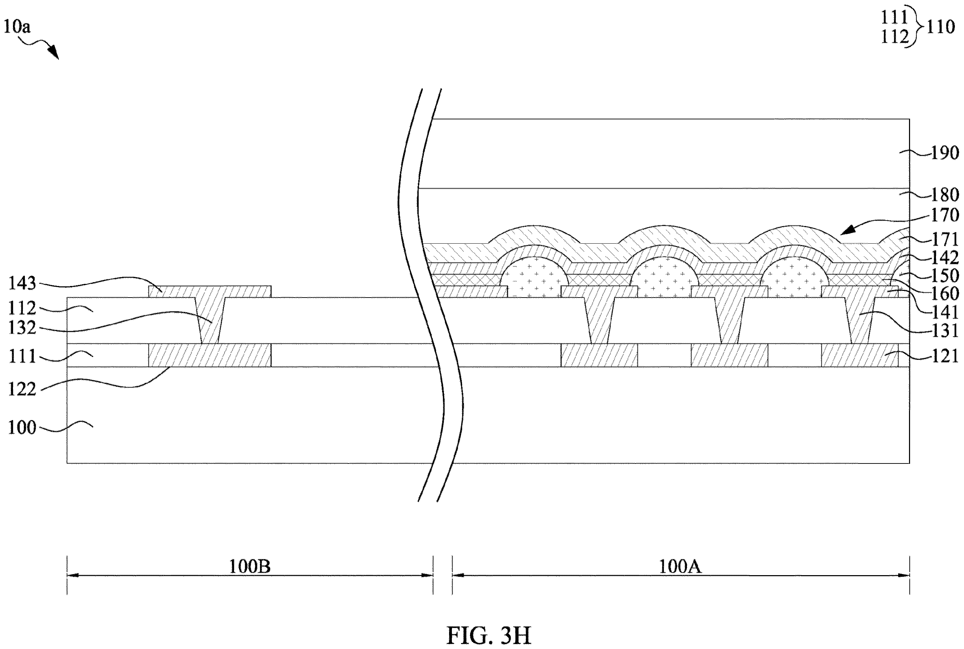

FIGS. 3A, 3B, 3C, 3D, 3E, 3F, 3G, and 3H show diagrams of a display device in different manufacturing stages of a method according to some embodiments of the present disclosure.

Referring to FIG. 3A, the substrate 100 is provided or received. The passivation layer 111 is formed on the substrate 100, the interconnection metal layer 121 is formed in the active region 100A, and the interconnection metal layer 122 is formed in the border region 100B. Next, the passivation layer 112 is formed on the interconnection metal layer 121.

Referring to FIG. 3B, openings 110p1 are formed to expose the interconnection metal layer 121. An opening 110p2 is formed to expose the interconnection metal layer 122. The opening 110p1 is located in the active region 100A. The opening 110p2 is located in the border region 100B. The opening 110p1 and the opening 110p2 pass through the passivation layer 112. The opening 110p1 and the opening 110p2 can be formed by an etching process (for example, dry etching). In some embodiments, the opening 110p1 and the opening 110p2 are formed or defined by the same mask and the same photolithography process.

Referring to FIG. 3C, a metal layer 140' (or a conductive layer) is formed on the passivation layer 112. The metal layer 140' fills the opening 110p1 and the opening 110p2. The metal layer 140' covers the active region 100A and the border region 100B.

Referring to FIG. 3D, a patterning process is performed to pattern the metal layer 140', so as to form the electrode 141 and the bonding pad 143. The electrode 141 and the bonding pad 143 are formed or defined by the same mask and the same photolithography process.

Referring to FIG. 3E, the pixel defining layer 150, the light emitting structure 160 and the electrode 142 are formed in the active region 100A, and then the electrode 141 is covered.

Referring to FIG. 3F, the film layer 170 is formed on the electrode 142. The film layer 170 has the portion 171 in the active region 100A, and has the portion 172 in the border region 100B. The portion 172 covers the bonding pad 143. The portions 171 and 172 are located at different heights relative to the substrate 100.

Referring to FIG. 3G, the flat layer 180 is formed on the portion 171, and the cover plate 190 is formed on the flat layer 180. The flat layer 180 and the cover plate 190 cover the active region 100A. The border region 100B is not covered by the flat layer 180 and the cover plate 190.

Referring to FIG. 3H, the portion 172 in the border region 100B is removed to expose the bonding pad 143, so as to manufacture the display device 10a.

The features of some embodiments are given in brief in the description above for a person skilled in the art to better understand various aspects of the present disclosure. A person skilled in the art would be able to understand that the present disclosure can be used as the basis for designing or modifying other manufacturing processes and structures so as to achieve the same objects and/or the same advantages of the embodiments described in the present application. A person skilled in the art would also be able to understand that such structures do not depart from the spirit and scope of the disclosure of the present application, and various changes, substitutions and replacements may be made by a person skilled in the art without departing from the spirit and scope of the present disclosure.

In addition, the scope of the present application is not limited to the specific embodiments of the processes, machinery, manufacturing, substance compositions, means, methods or steps given in the detailed description. A person of ordinary skill in the art would be able to understand from the disclosed details of the present disclosure that existing or future processes, machinery, manufacturing, substance compositions, means, methods or steps that have the same functions or achieve substantially the same results as the corresponding embodiments given in the literature can be used according to the present disclosure. Accordingly, these processes, machinery, manufacturing, substance compositions, means, methods and steps to be encompassed within the scope of the appended claims of the present application.

## Claims

1. A display device (10a, 10b), comprising:
a substrate (100), comprising an active region and a border region;
a first interconnection metal layer (121), disposed on the substrate and located in the active region;
a second interconnection metal layer (122), disposed on the substrate and located in the border region;
a passivation layer (112), disposed on the first interconnection metal layer and the second interconnection metal layer;
a first through via (131), passing through the passivation layer and electrically connected to the first interconnection metal layer;
a second through via (132), passing through the passivation layer and electrically connected to the second interconnection metal layer;
a first electrode (141), disposed on the first through via; and
a bonding pad (143), disposed on the second through via.

2. The display device according to claim 1, further comprising:
a light emitting structure (160), located on the first electrode; and
a second electrode (142), located on the light emitting structure.

3. The display device according to claim 1 or 2, further comprising:
a cover plate (190), covering the second electrode, wherein the bonding pad is free from being covered by the cover plate.

4. The display device according to any of claims 1-3, wherein a height of the bonding pad relative to the substrate is equal to a height of the first electrode relative to the substrate.

5. The display device according to any of claims 1-4, wherein an aperture of the first through via is equal to an aperture of the second through via.

6. The display device according to any of claims 1-5, wherein a width of the bonding pad is greater than a width of the first electrode in a cross-sectional view.

7. The display device according to any of claims 1-6, wherein a height of the first interconnection metal layer relative to the first electrode is equal to a height of the second interconnection metal layer relative to the bonding pad.

8. A method for forming a display device, comprising:
providing a substrate (100) comprising an active region (100A) and a border region (100B);
forming a first interconnection metal layer (121) on the substrate and located in the active region;
forming a second interconnection metal layer (122) on the substrate and located in the border region;
forming a passivation layer (112) on the first interconnection metal layer and the second interconnection metal layer;
forming a first through via (131) passing through the passivation layer and electrically connected to the first interconnection metal layer;
forming a second through via (132) passing through the passivation layer and electrically connected to the second interconnection metal layer;
forming a first electrode (141) on the first through via; and
forming a bonding pad (143) on the second through via.

9. The method according to claim 8, wherein forming of the first electrode and the bonding pad comprises:
forming a conductive layer (140') covering the active region and the border region; and
patterning the conductive layer so as to form the first electrode and the bonding pad.

10. The method according to claim 8 or 9, further comprising:
forming a light emitting structure (160) on the first electrode;
forming a second electrode (142) on the light emitting structure; and
forming a cover plate (190) covering the active region of the substrate.

11. The method according to any of claims 8-10, further comprising:
patterning the passivation layer to form a first opening (110p1) exposing the first interconnection metal layer and a second opening (110p2) exposing the second interconnection metal layer; and
forming the first though via within the first opening and the second through via within the second opening.

12. The method according to claim 11, wherein the first opening and the second opening are defined by one mask.

13. The method according to claim 10, further comprising:
forming a film (170) covering the second electrode and covering the bonding pad; and
patterning the film to expose the bonding pad.

14. The method according to claim 13, wherein a height of a first portion (171) of the film covering the second electrode is different from a height of a second portion (172) of the film covering the bonding pad.

15. The method according to claim 13, wherein the border region is free from being covered by the film.
